# EUROPÄISCHE PATENTSCHRIFT

(11) **EP 1 214 782 B1**
(45) Veröffentlichungstag und Bekanntmachung des Hinweises auf die Patenterteilung: **14.05.2003**
(21) Anmeldenummer: 00958533.2
(22) Anmeldetag: 12.09.2000
(51) Int. Cl.: H03G 7/00

(54) **VERSTÄRKERSCHALTUNG MIT ABSCHNITTSWEISE LINEARER ÜBERTRAGUNGSFUNKTION**
AMPLIFIER CIRCUIT WITH A SECTIONAL LINEAR TRANSMISSION FUNCTION
CIRCUIT AMPLIFICATEUR POURVU D'UNE FONCTION DE TRANSMISSION LINEAIRE DANS UNE SECTION

(30) Priorität: 17.09.1999 DE 19944707
(43) Veröffentlichungstag der Anmeldung: 19.06.2002
(73) Patentinhaber: Micronas Munich GmbH, 81541 München (DE)
(72) Erfinder: KUTTNER, Franz, A-9524 St. Ulrich (AT)
(74) Vertreter: Bickel, Michael
(86) Internationale Anmeldenummer: EP0008917
(87) Internationale Veröffentlichungsnummer: WO01022578

(56) Entgegenhaltungen:
- EP-A- 0 414 159
- US-A- 5 703 535
- US-A- 5 812 218
- PATENT ABSTRACTS OF JAPAN vol. 018, no. 676 (P-1847), 20. Dezember 1994 (1994-12-20) & JP 06 266865 A (FUJI ELECTRIC CO LTD), 22. September 1994 (1994-09-22)

## Beschreibung

Die Erfindung betrifft eine Verstärkerschaltung mit einem Differenzverstärker, die eine in Abschnitten lineare Kennlinie aufweist, die einstellbar ist.

Im allgemeinen ist man bestrebt, Verstärkerschaltungen aufzubauen, die über den gesamten Ansteuerungsbereich eine lineare Kennlinie aufweisen. Die Steigung der linearen Kennlinie und somit der Verstärkungsfaktor der Verstärkungsschaltung ist über den gesamten Bereich der zulässigen Eingangswerte konstant.

Bei bestimmten Anwendungen ist es wünschenswert, wenn der Verstärkungsfaktor nur bis zu einer bestimmten Schwelle eines Eingangswertes konstant ist. Oberhalb dieser Schwelle werden die Eingangswerte mit einem anderen Verstärkungsfaktor verstärkt. Sind zwei Bereiche mit jeweils konstantem, aber unterschiedlichem Verstärkungsfaktor vorhanden, so weist eine Verstärkerschaltung mit diesem Verhalten eineÜbertragungskennlinie, die die Ausgangswerte in Abhängigkeit der Eingangswerte beschreibt, mit einem Knick auf.

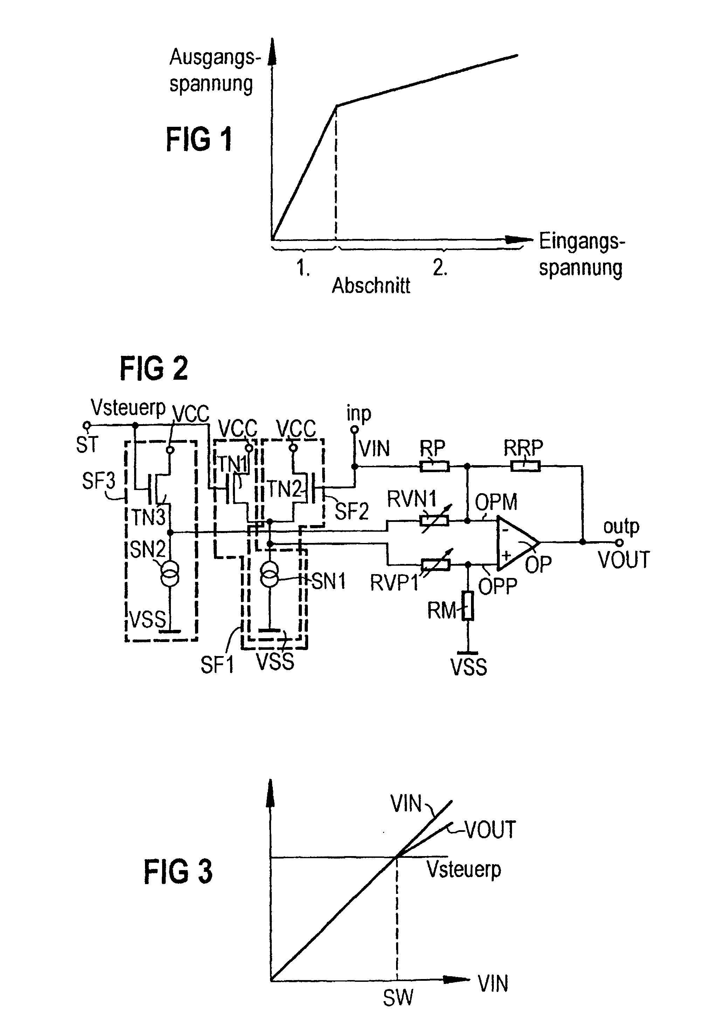

Figur 1 zeigt eine Kennlinie einer Verstärkerschaltung, bei der eine Ausgangsspannung über einer Eingangsspannung aufgetragen ist. Die Kennlinie verläuft sowohl in einem ersten Abschnitt als auch in einem zweiten Abschnitt linear. Die Steigung der Kurve im ersten Abschnitt ist verschieden von derjenigen im zweiten Abschnitt.

Verstärkerschaltungen mit abschnittsweise linearer Übertragungsfunktion, die aus Differenzverstärkern aufgebaut sind, sind beispielsweise aus Allen, P.E. (Phillip E.): CMOS analog circuit design, 1987, S. 622-627 bekannt. Die Grundstruktur dieser Schaltungen besteht aus einem invertierenden Halbwellengleichrichter. Der Nachteil dieser Schaltungen sind zwei Dioden im Rückkoppelzweig des Differenzverstärkers. Wenn sich die Eingangsspannung einer solchen Verstärkerschaltung mit Halbwellengleichrichter von positiv auf negativ ändert, muß sich die Ausangsspannung des Differenzverstärkers um zwei Diodendurchlaßspannungen ändern. Durch die beschränkte Bandbreite des Differenzverstärkers und der begrenzten Slew-Rate des Differenzverstärkers kann diese Änderung nur in einer bestimmten Mindestzeit erfolgen. Diese Verstärkerschaltungen - mit Dioden im Rückkoppelzweig sind in ihrer Bandbreite derart begrenzt, daß sie für Anwendungen mit Videosignalen nicht einsetzbar sind. Üblicherweise ist bei Videosignalen eine Bandbreite von mindestens 30 MHz erforderlich.

Aufgabe der vorliegenden Erfindung ist es, eine Verstärkerschaltung mit einem Differenzverstärker anzugeben, die eine einstellbare abschnittsweise lineare Übertragungskennlinie aufweist und ohne Dioden im Rückkoppelzweig des Differenzverstärkers auskommt. Die Verstärkerschaltung soll zur Verarbeitung von Videosignalen geeignet sein.

Gelöst wird diese Aufgabe mit einer Verstärkerschaltung mit den Merkmalen des Patentanspruches 1.

Die erfindungsgemäße Schaltung hat den Vorteil, daß gegenüber bekannten Verstärkerschaltungen keine Dioden im Rückkoppelzweig des Differenzverstärkers erforderlich sind. Die Rückkopplung des Ausgangs des Differenzverstärkers einen seiner Eingänge kann mit Bauelementen erfolgen, die ein lineares Verhalten zwischen Strom- und Spannung aufweisen, wie es beispielsweise bei ohmschen Widerständen der Fall ist.

Wegen der großen Bandbreite, die mit der erfindungsgemäßen Verstärkerschaltung erreichbar ist, kann sie zur Verstärkung von Videosignalen, z. B. Fernsehsignalen eingesetzt werden.

Die Verstärkerschaltung kann auch für differentielle Eingangssignale ausgelegt werden.

Ein weiterer Vorteil der erfindungsgemäßen Verstärkerschaltung liegt darin, daß der Knick in der Übertragungskennlinie nicht durch die Rückkopplung des Differenzverstärkers hervorgerufen wird. Dadurch ist die Schaltung auch bei hohen Frequenzen stabil.

Um eine Verstärkerschaltung für differentielle Eingangssignale zu erhalten, wird zweckmäßigerweise das Ausführungsbeispiel für nicht-differentielle Eingangssignale derart erweitert, daß die Eingangsschaltung aus n-Kanal Sourcefolgern am Differenzverstärker durch eine entsprechende Eingangsschaltung aus p-Kanal Sourcefolgern für den zweiten Eingangsanschluß erweitert wird.

Ausgestaltungen der Erfindung sind in Unteransprüchen gekennzeichnet.

Die Erfindung wird nachfolgend anhand von in den Figuren der Zeichnung dargestellten Ausführungsbeispielen näher erläutert. Entsprechende Elemente sind mit gleichen Bezugszeichen versehen. Es zeigen:
- Figur 1: eine Übertragungskennlinie mit Knick,
- Figur 2: ein Schaltbild einer erfindungsgemäßen Verstärkerschaltung,
- Figur 3: eine Übertragungskennlinie der Verstärkerschaltung nach Figur 2 und
- Figur 4: ein weiteres Schaltbild einer erfindungsgemäßen Verstärkerschaltung.

Nach Figur 2 weist ein erstes Ausführungsbeispiel der Verstärkerschaltung einen Operationsverstärker OP als Differenzverstärker mit einem invertierenden Eingang OPM und einem nicht-invertierenden Eingang OPP zur Erzeugung eines Ausgangssignals auf. Ein Ausgang OUTP des Operationsverstärkers OP bildet zugleich einen Ausgang der Verstärkerschaltung dieses Ausführungsbeispiels. Der nicht-invertierende Eingang OPP ist über einen ersten einstellbaren Widerstand RVP1 mit einem Ausgang eines ersten Sourcefolgers SF1 und einem Ausgang eines zweiten Sourcefolgers SF2 verbunden. Der erste Sourcefolger SF1 enthält einen ersten Feldeffekttransistor TN1, der mit seinem Drain-Anschluß an ein erstes Bezugspotential VCC angeschlossen ist. Sein Source-Anschluß ist über eine Stromquelle SN1 mit einem zweiten Bezugspotential VSS verbunden.

Der zweite Sourcefolger SF2 enthält einen zweiten Feldeffekt-Transistor TN2, der mit seinem Drain-Anschluß ebenfalls an dem ersten Bezugspotential VCC und mit seinem Source-Anschluß an dem Source-Anschluß des ersten Feldeffekt-Transistors TN1 angeschlossen ist. Der zweite Sourcefolger SF2 ist über die erste Stromquelle SN1 mit dem zweiten Bezugspotential VSS verbunden. Die erste Stromquelle SN1 wird also von beiden Sourcefolgern SN1, SF2 verwendet. Die gemeinsamen Source-Anschlüsse der Transistoren TN1 und TN2 bilden den Ausgang des Sourcefolgers SF1 bzw. SF2.

Der invertierende Eingang OPM des Operationsverstärkers OP ist über einen zweiten einstellbaren Widerstand RVN1 mit einem Ausgang eines dritten Sourcefolgers SF3 verbunden. Dieser enthält eine Reihenschaltung aus einem dritten Feldeffekttransistor TN3 und einer zweiten Stromquelle SN2, die zwischen das erste Bezugspotential VCC und das zweite Bezugspotential VSS geschaltet ist.

Die Transistoren TN1, TN2 und TN3 sind in diesem Ausführungsbeispiel vom n-Kanal-Leitungstyp. Werden die Polaritäten umgepolt, können anstelle der n-Kanal-Typen auch p-Kanal-Typen eingesetzt werden.

Die Gate-Anschlüsse des ersten Transistors TN1 und des dritten Transistors TN3 sind miteinander verbunden und bilden einen Steueranschluß ST. Dem Gate-Anschluß des zweiten Transistors TN2 ist das Eingangssignal INP der Verstärkerschaltung zuführbar. Das Gate des Transistors TN2 ist über einen ersten Eingangswiderstand RP mit dem invertierenden Eingang OPM des Operationsverstärkers OP verbunden. Der Ausgang OUTP des Operationsverstärkers OP ist über einen ersten Rückkopplungswiderstand RRP auf den invertierenden Eingang OPM zurückgekoppelt. Der nicht-invertierende Eingang OPP ist über einen Massewiderstand RM mit dem zweiten Bezugspotential VSS verbunden.

Der erste und der dritte Sourcefolgers SF1, SF3 werden jeweils über die Gate-Anschlüsse des ersten und dritten Transistors TN1, TN3 mit einer festen Steuerspannung Vsteuerp betrieben. Da dem ersten Sourcefolger SF1 ein zweiter Sourcefolger SF2 parallelgeschaltet ist, kann die Spannung an den Ausgängen der beiden Sourcefolger SF1, SF2 nicht unter einen bestimmten Wert fallen. Dieser Wert ergibt sich aus der Steuerspannung Vsteuerp vermindert um eine Spannung, die über dem ersten Transistor TN1 abfällt. Oberhalb dieses Wertes folgen die Ausgänge der Sourcefolger SF1 und SF2 einer Eingangsspannung VIN am Eingangsanschluß INP, wiederum vermindert um einen Spannungsabfall über dem zweiten Transistor TN2. Zur Verstärkung der Spannung am Ausgang des Sourcefolgers SF1 oder SF2 wird der Operationsverstärker OP verwendet, an dessen invertierenden Eingang OPM der Ausgang des dritten Sourcefolgers SF3, der wie der erste Sourcefolger SF1 aufgebaut ist und ebenfalls von der Steuerspannung Vsteuerp angesteuert wird, angeschlossen.

In Figur 3 ist die Eingangsspannung VIN der Verstärkerschaltung über einer Ausgangsspannung VOUT am Ausgang OUTP des Operationsverstärkers aufgetragen. Die Steuerspannung Vsteuerp ist konstant. Die Höhe der Steuerspannung Vsteuerp bestimmt, bei welcher Eingangsspannung VIN der Knick in der Übertragungskennlinie auftritt. Unterhalb eines Schwellenwertes SW der Eingangsspannung VIN ist die Ausgangsspannung VOUT der Eingangsspannung VIN proportional. Oberhalb des Schwellenwertes SW steigt die Ausgangsspannung VOUT langsamer als die Eingangsspannung VIN. Der Operationsverstärker OP bildet die Differenz der Ausgangsspannung des dritten Sourcefolgers SF3 und der Spannung des Ausgangs des Sourcefolgers SF1 bzw.SF2.

Über die einstellbaren Widerstände RVN1, RVN2 kann bei einem festen Wert der Steuerspannung Vsteuerp der Schwellenwert SW eingestellt werden.

Die Eingangsspannung VIN der Verstärkerschaltung ergibt sich aus der Differenz des Potentials am Eingangsanschluß INP mit dem zweiten Bezugspotential VSS. Das Bezugspotential VSS ist konstant. Bei einem differentiellen Eingangssignal ist keines der Potentiale am Eingangsanschluß der Verstärkerschaltung konstant.

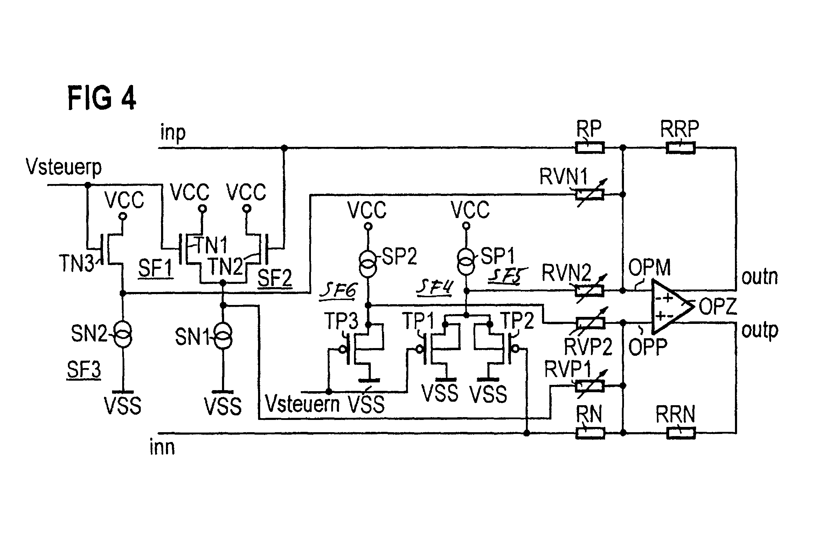

Figur 4 zeigt ein Schaltbild eines Ausführungsbeispieles der Verstärkerschaltung, mit der ein differentielles Eingangssignal, das aus der Differenz eines positiven Eingangspotentials INP und eines negativen Eingangspotentials INN gebildet wird, verstärkt werden kann. Diese Schaltung weist einen Operationsverstärker mit einem Ausgangsanschluß für ein negatives Ausgangssignal OUTN und einen Ausgangsanschluß für ein positives Ausgangssignal OUTP auf.

Die Sourcefolger SF1, SF2 und SF3 sind wie bei der Schaltung nach Figur 2 aufgebaut. Das positive Eingangspotential INP ist zum einen mit dem Gate-Anschluß des zweiten Transistors TN2 und zum anderen über einen Rückkopplungswiderstand RRP mit dem invertierenden Eingang OPM des Operationsverstärkers OPZ verbunden. Mit diesem Eingang OPM ist über den zweiten einstellbaren Widerstand RVN1 der Ausgang des dritten Sourcefolgers SF3 verbunden. Der Ausgang des Sourcefolgers SF1 bzw. SF2 ist über den ersten einstellbaren Widerstand RVP1 mit dem nicht-invertierenden Eingang OPP des Operationsverstärkers OPZ verbunden. Über einen Rückkopplungswiderstand RRP ist der positive Ausgang OUTP des Operationsverstärkers OPZ auf den invertierenden Eingang OPN rückgekoppelt.

Zusätzlich zu der Schaltung nach Figur 2 sind ein vierter Sourcefolger SF4, ein fünfter Sourcefolger SF5 und ein sechster Sourcefolger SF6 vorhanden. Die Sourcefolger SF4 und SF5, SF6 enthalten jeweils einen Feldeffekt-Transistors vom p-Kanal-Leitungstyp. Der sechste Sourcefolger SF6 weist einen Transistor TP3 auf, dessen Source-Anschluß mit dem zweiten Bezugspotential VSS verbunden ist und dessen Drain-Anschluß über eine dritte Stromquelle SP2 mit dem ersten Versorgungspotential VCC verbunden ist. Der Ausgang des sechsten Sourcefolgers ist über einen dritten einstellbaren Widerstand RVP2 mit dem nicht-invertierenden Eingang OPP verbunden. Ein erster p-Kanal-Transistor TP1 bildet mit einer vierten Stromquelle SP1 den Sourcefolger SF4. Der fünfte Sourcefolger SF5 wird von einem zweiten p-Kanal-Transistor TP2 und der vierten Stromquelle SP1 gebildet. Die vierte Stromquelle SP1 wird also von den beiden Sourcefolgern SF4 und SF5 gemeinsam benutzt.

Die Drain-Anschlüsse der p-Kanal-Transistoren TP1 und TP2 bilden einen gemeinsamen Ausgang, der über einen vierten einstellbaren Widerstand RVN2 mit dem invertierenden Eingang OPN verbunden ist. Dem Gate-Anschluß des dritten p-Kanal-Transistors TP3 und dem Gate-Anschluß des ersten p-Kanal-Transistors TP1 ist ein negatives Steuersignal Vsteuern zuführbar. Das negative Eingangssignal INN wird dem Gate-Anschluß des zweiten p-Kanal-Transistors TP2 zugeführt. Dieser Gate-Anschluß ist über einen zweiten Eingangswiderstand RN mit dem nicht-invertierenden Eingang OPP verbunden. Das negative Ausgangssignal OUTN des Operationsverstärkers OPZ ist über einen zweiten Rückkopplungswiderstand RRN an den nicht-invertierenden Eingang OPP angeschlossen.

Die Verstärkerschaltung eignet sich insbesondere zum Einsatz in der Videotechnik, so beispielsweise bei der Strahlstrombegrenzung in Kathodenstrahlröhren beim sogenannten Blue- oder auch Black-Stretch.

Beim Black-Stretch werden bei einem Videobild, das keinen völlig schwarzen Anteil aufweist, die Farbwerte für Dunkelgrau durch Farbwerte für Schwarz ersetzt und somit Dunkelgrau zu Schwarz hin gestreckt. Dadurch wird eine höhere Dynamik im Bild erzielt.

Beim Blue-Stretch werden die roten und grünen Signale ab einem bestimmten Pegel reduziert, um das Bild brillianter erscheinen zu lassen.

## Patentansprüche

1. Verstärkerschaltung mit einstellbarer Kennlinie mit einem Eingangsanschluß für ein Eingangssignal (VIN, INP) und einem Differenzverstärker (OP) zur Erzeugung eines Ausgangssignals mit einem invertierenden (OPM) und einem nichtinvertierenden (OPP) Eingang,
**gekennzeichnet durch** einen ersten (SF1) und einen zweiten (SF2) Sourcefolger, die jeweils ausgangsseitig mit einem der Eingänge (OPP) des Differenzverstärkers (OP) verbunden sind, und einem dritten Sourcefolger (SF3), der ausgangsseitig mit einem anderen (OPM) der Eingänge des Differenzverstärkers (OP) verbunden ist, wobei der erste (SF1) und dritte (SF3) Sourcefolger eingangsseitig mit einem Anschluß für ein Konstantpotential (Vsteuerp) zur Einstellung der Kennlinie und der zweite Sourcefolger (SF2) eingangsseitig mit dem Eingangsanschluß verbunden ist.

2. Verstärkerschaltung nach Anspruch 1,
**dadurch gekennzeichnet,**
**daß** der erste, zweite und dritte Sourcefolger (SF1, SF2, SF3) jeweils zwischen zwei Bezugspotentialen (VSS, VCC) eine Reihenschaltung aus jeweils einem Feldeffekttransistor (TN1, TN2, TN3) und einer Stromquelle (SN1, SN2) enthält.

3. Verstärkerschaltung nach Patentanspruch 2,
**dadurch gekennzeichnet,**
**daß** der erste und zweite Sourcefolger (SF1, SF2) eine gemeinsame Stromquelle (SN1) aufweisen.

4. Verstärkerschaltung nach einem der Ansprüche 1 bis 3,
**dadurch gekennzeichnet,**
**daß** weiterhin vorgesehen sind ein weiterer Eingangsanschluß für ein zu dem Eingangssignal (INP) inverses weiteres Eingangssignal (INN), ein vierter und ein fünfter Sourcefolger (SF4, SF5), die ausgangsseitig mit dem anderen der Eingänge (OPM) des Differenzverstärkers (OP) verbunden sind und ein sechster Sourcefolger (SF6), der ausgangsseitig mit dem einen der Eingänge (OPP) des Differenzverstärkers (OP) verbunden ist, wobei der vierte und der sechste Sourcefolger (SF4, SF6) eingangsseitig mit dem Anschluß für ein weiteres Konstantpotential (Vsteuern), das zu dem einen Konstantpotential (Vsteuerp) umgekehrte Polarität aufweist, und der fünfte Sourcefolger (SF5) eingangsseitig mit dem weiteren Eingangsanschluß verbunden ist und der Differenzverstärker (OP) einen zusätzlichen inversen Ausgang (OUTN) aufweist.

5. Verstärkerschaltung nach einem der Ansprüche 1 bis 4,
**dadurch gekennzeichnet,**
**daß** den Eingängen (OPN, OPP) des Differenzverstärkers (OP) einstellbare Widerstände (RVP1, RVP2, RVN1,RVN2) vorgeschaltet sind.

6. Verstärkerschaltung nach einem der Ansprüche 4 oder 5,
**dadurch gekennzeichnet,**
**daß** der erste, zweite und dritte Sourcefolger (SF1, SF2, SF3) von einem ersten Leitungstyp (n-Kanal), der vierte, fünfte und sechste Sourcefolger (SF4, SF5, SF6) von einem vom ersten verschiedenen Leitungstyp (p-Kanal) sind.

## Claims

1. An amplifier circuit with adjustable characteristic with an input connection for an input signal (VIN, INP) and a difference amplifier (OP) for generating an output signal with an inverting (OPM) and a noninverting (OPP) input,
**characterised by** a first (SF1) and a second (SF2) common drain connection, which in each case are connected at the output side with one of the inputs (OPP) of the difference amplifier (OP), and a third common drain connection (SF3), which is connected at the output side with another (OPM) of the inputs of the difference amplifier (OP), the first (SF1) and third (SF3) common drain connection being connected at the input side to a connection for a constant potential (Vcontrolp) for adjusting the characteristic and the second common drain connection (SF2) being connected at the input side to the input connection.

2. An amplifier circuit according to Claim 1,
**characterised in that** the first, second and third common drain connection (SF1, SF2, SF3), in each case between two reference potentials (VSS, VCC), contains a series circuit consisting of in each case a field-effect transistor (TN1, TN2, TN3) and a current source (SN1, SN2).

3. An amplifier circuit according to Patent Claim 2,
**characterised in that** the first and second common drain connection (SF1, SF2) have a common current source (SN1).

4. An amplifier circuit according to one of Claims 1 to 3,
**characterised in that** also provided are a further input connection for a further input signal (INN) which is inverse to the input signal (INP), a fourth and a fifth common drain connection (SF4, SF5), which are connected at the output side to the other of the inputs (OPM) of the difference amplifier (OP), and a sixth common drain connection (SF6), which is connected at the output side to the one of the inputs (OPP) of the difference amplifier (OP), the fourth and the sixth common drain connections (SF4, SF6) being connected at the input side to the connection for a further constant potential (Vcontrol), which has a polarity that is reversed to the one constant potential (Vcontrolp), and the fifth common drain connection (SF5) being connected at the input side to the other input connection and the difference amplifier (OP) comprising an additional inverse output (OUTN).

5. An amplifier circuit according to one of Claims 1 to 4,
**characterised in that** adjustable resistors (RVP1, RVP2, RVN1, RVN2) are connected in front of the inputs (OPN, OPP) of the difference amplifier (OP).

6. An amplifier circuit according to one of Claims 4 or 5,
**characterised in that** the first, second and third common drain connections (SF1, SF2, SF3) are of a first conducting type (n channel), and the fourth, fifth and sixth common drain connections (SF4, SF5, SF6) are of a conducting type different from the first (p channel).

## Revendications

1. Circuit amplificateur à caractéristique réglable comportant un branchement d'entrée pour un signal d'entrée (VIN, INP) et un amplificateur de différence (OP) pour générer un signal de sortie à entrée inversée (OPM) et entrée non inversée (OPP),
**caractérisé par**
un premier et un second circuit (SF1, SF2) à charge de source, reliés respectivement en sortie à l'une des entrées (OPP) de l'amplificateur de différence (OP) et un troisième circuit à charge de source (SF3) dont la sortie est reliée à une autre (OPM) des entrées de l'amplificateur de différence (OP), le premier et le troisième circuit à charge de source (SF1, SF3) étant reliés du côté de l'entrée à un branchement pour un potentiel constant (Vsteuerp) pour régler la caractéristique, et l'entrée du second circuit à charge de source (SF2) étant reliée au branchement d'entrée.

2. Circuit amplificateur selon la revendication 1,
**caractérisé en ce que**
le premier, le second et le troisième circuits à charge de source (SF1, SF2, SF3) comportent chaque fois entre deux potentiels de référence (VSS, VCC), un circuit série formé chaque fois d'un transistor à effet de champ (TN1, TN2, TN3) et d'une source de courant (SN1, SN2).

3. Circuit amplificateur selon la revendication 2,
**caractérisé en ce que**
le premier et le second circuits à charge de source (SF1, SF2) ont une source de courant (SN1) commune.

4. Circuit amplificateur selon l'une des revendications 1 à 3,
**caractérisé en outre par**
un autre branchement d'entrée pour un autre signal d'entrée (INN) inverse, au signal d'entrée (INP), un quatrième et cinquième circuits à charge de source (SF4, SF5), reliés en sortie à l'autre des entrées (ONP) de l'amplificateur de différence (OP) et un sixième circuit à charge de source (SF6) relié en sortie à l'une des entrées (OPP) de l'amplificateur de différence (OP), le quatrième et le sixième circuits à charge de source (SF4, SF6) étant reliés en entrée au branchement d'un autre potentiel constant (Vsteuern), de polarité opposée à celle du potentiel constant (Vsteuerp), et le cinquième circuit à charge de source (SF5) étant relié en entrée à l'autre branchement d'entrée tandis que l'amplificateur de différence (OP) comporte une sortie inverse (OUTN) supplémentaire.

5. Circuit amplificateur selon l'une des revendications 1 à 4,
**caractérisé en ce que**
des résistances réglables (RVP1, RVP2, RVN1, RVN2) sont montées en amont des entrées (OPN, OPP) de l'amplificateur de différence (OP).

6. Circuit amplificateur selon l'une des revendications 4 ou 5,
**caractérisé en ce que**
le premier, le second et le troisième circuit à charge de source (SF1, SF2, SF3) sont d'un premier type de conduction (canal n), et le quatrième, le cinquième et le sixième circuits à charge de source (SF4, SF5, SF6) sont d'un type de conduction (canal p), différent du premier type.
